# EUROPÄISCHE PATENTSCHRIFT

(11) **EP 2 592 244 B1**
(45) Veröffentlichungstag und Bekanntmachung des Hinweises auf die Patenterteilung: **14.05.2014**
(21) Anmeldenummer: 13153620.3
(22) Anmeldetag: 02.08.2011
(51) Int. Cl.: H01L 35/30, F01N 5/00, F01N 1/00, F01N 5/02

(54) **Schalldämpfer**
Muffler
Silencieux

(30) Priorität: 06.08.2010 DE 102010033607
(43) Veröffentlichungstag der Anmeldung: 15.05.2013
(62) Teilanmeldung aus: 11740578.7
(73) Patentinhaber: Friedrich Boysen GmbH & Co. KG, 72213 Altensteig (DE)
(72) Erfinder: Schmidt, Dr. Jürgen, 75417 Mühlacker (DE); Herbig, Dr. Michael, 72250 Freudenstadt (DE)
(74) Vertreter: Manitz, Finsterwald & Partner GbR

(56) Entgegenhaltungen:
- DE-U1-202010 003 049
- US-A1- 2005 284 623
- US-A1- 2007 045 044

## Beschreibung

Die Erfindung betrifft einen Schalldämpfer für eine Abgasanlage einer Brennkraftmaschine mit einem Schalldämpfergehäuse, mindestens einem Abgaseinlass, mindestens einem Abgasauslass und mindestens einer im Schalldämpfergehäuse angeordneten Schalldämpfungseinrichtung gemäß dem Oberbegriff von Anspruch 1. Ein derartiger Schalldämpfer ist in US 2005/0284623 A1 offenbart. Weitere Schalldämpfer, bei denen dem durchströmenden Abgas Wärme entzogen wird, sind aus DE 10 2010 003 049 U1 und US 2007/0045044 A1 bekannt.

In Abgasanlagen von Brennkraftmaschinen werden Schalldämpfer vorgesehen, um Druckstöße zu dämpfen, die beim schnellen Öffnen der Auslassventile entstehen, und damit die Schallemission zu reduzieren. Im Inneren des Schalldämpfergehäuses werden zum Zweck der Schalldämpfung verschiedene Arten von Schalldämpfungseinrichtungen angeordnet. Diese umfassen z.B. gelochte Rohre, Kammern, Dämmmaterial und/oder Rohre mit sich änderndem Querschnitt. Weitere Schalldämpfungseinrichtungen bestehen in Anordnungen, welche den Abgasstrom in mehrere unterschiedlich lange Teilströme aufspalten, wodurch sich Schallwellen aufgrund von Interferenzeffekten durch phasenverschobene Überlagerung teilweise gegenseitig auslöschen.

Es ist bekannt, dass bei Brennkraftmaschinen ein erheblicher Anteil der vom Kraftstoff zugeführten Energie in Form von Wärmeenergie durch die Abgasanlage verloren geht. Daher ist es wünschenswert, zumindest einen Teil dieser im Abgas vorhandenen Abwärme zu nutzen, indem diese in nutzbare Energie umgewandelt wird. Insbesondere bei in Kraftfahrzeugen eingebauten Brennkraftmaschinen steht für die Abgasanlage aber nur ein sehr begrenzter Bauraum zur Verfügung. Es ist daher häufig schwierig, zusätzliche, zur Nutzung der Abwärme erforderliche Einrichtungen in die Abgasanlage zu integrieren.

Es ist die Aufgabe der vorliegenden Erfindung, einen Schalldämpfer anzugeben, welcher die im Abgas enthaltene Wärmeenergie in Nutzenergie umwandeln kann und nur einen geringen Bauraum beansprucht.

Die Aufgabe wird durch einen Schalldämpfer mit den Merkmalen des Anspruchs 1 gelöst. Es ist vorgesehen, dass im Schalldämpfergehäuse mindestens ein Kühlungselement angeordnet ist, welches ausgebildet ist, um dem Abgas Wärmeenergie zu entziehen.

Hierbei wird ausgenutzt, dass durch das Kühlungselement dem Abgas Wärmeenergie entzogen wird. Die dadurch hervorgerufene Abkühlung bewirkt eine Verminderung des Abgasvolumenstroms sowie der durch die Abgasanlage abgeleiteten Druckstöße oder Schallwellen und damit eine Reduktion der Schallemission. Die dem Abgas entzogene Wärmeenergie kann anderweitig genutzt werden und damit auf vorteilhafte Weise zu einer Effizienzsteigerung der Brennkraftmaschine beitragen.

Erfindungsgemäß ist das Kühlungselement ein thermoelektrischer Generator, dessen Hochtemperaturseite mit dem Abgas in Wärmeübertragungsverbindung steht und dessen Niedertemperaturseite vom Abgas abgeschirmt ist.

Bei thermoelektrischen Generatoren wird aufgrund des Seebeck-Effekts zwischen zwei aus unterschiedlichem Material bestehenden Leitern, die an einem Ende miteinander verbunden sind, bei einer Temperaturdifferenz eine elektrische Spannung erzeugt. Die Verbindungsstelle und die freien Enden müssen somit unterschiedliche Temperaturen aufweisen. Die beiden Leiter bestehen aus unterschiedlichen Metallen oder aber aus zwei unterschiedlich dotierten Halbleitermaterialien und bilden ein so genanntes Thermoelement. Bei einem thermoelektrischen Generator ist in der Regel eine Vielzahl von Thermoelementen miteinander verschaltet, um die gewünschten Spannungen oder Stromstärken zu erreichen.

Indem bei einem Schalldämpfergehäuse die Hochtemperaturseite des thermoelektrischen Generators mit dem Abgas thermisch gekoppelt und die Niedertemperaturseite vom Abgas abgeschirmt ist, wird die zur Erzeugung von Nutzenergie in Form von elektrischer Energie notwendige Temperaturdifferenz erreicht. Durch die Erzeugung von elektrischer Energie durch den thermoelektrischen Generator wird dem Abgas Wärmeenergie entzogen. Die dadurch hervorgerufene Abkühlung bewirkt zugleich die erwünschte Verminderung des Abgasvolumens, Die elektrische Energie kann beispielsweise in das Bordnetz eines Kraftfahrzeugs eingespeist werden, so dass die üblicherweise vorhandene, von der Brennkraftmaschine angetriebene Lichtmaschine entlastet oder sogar komplett überflüssig wird.

Durch die Integration des thermoelektrischen Generators in den Schalldämpfer ist der zusätzliche Platzbedarf gering, da in den Schalldämpfern in der Regel ein ausreichender Bauraum für den Einbau von thermoelektrischen Generatoren zur Verfügung steht.

Durch die Ausnutzung der schalldämpfenden Wirkung des thermoelektrischen Generators kann der für dessen Integration in das Schalldämpfergehäuse erforderliche Einbauraum kompensiert werden, so dass letztlich ein mit einem thermoelektrischen Generator versehener Schalldämpfer bei gleicher Schalldämpfungsleistung kleiner oder zumindest nicht größer ist als ein herkömmlicher Schalldämpfer ohne thermoelektrischen Generator.

Erfindungsgemäß ist im Schalldämpfergehäuse mindestens ein abgasdurchströmbarer Rohrkanal, insbesondere Flachkanal angeordnet, welcher mit dem Kühlungselement, insbesondere der Hochtemperaturseite des thermoelektrischen Generators, thermisch gekoppelt ist. Dadurch wird die gewünschte Abschirmung der Niedertemperaturseite vom Abgas erreicht und gleichzeitig ein die Lebensdauer vermindernder direkter Kontakt des Abgases mit dem thermoelektrischen Generator vermieden.

Erfindungsgemäß umfasst die Schalldämpfungseinrichtung den Rohrkanal. Hierbei erfolgt die Schalldämpfung unmittelbar durch die Abkühlung des den Rohrkanal durchströmenden Abgases durch Entzug der Wärmeenergie.

Erfindungsgemäß ist in dem Schalldämpfergehäuse außer dem Rohrkanal keine weitere Schalldämpfungseinrichtung angeordnet. Hierdurch kann ein großer Anteil des in dem Schalldämpfergehäuse zur Verfügung stehenden Bauraums für die Anordnung von einem oder mehreren thermoelektrischen Generatoren ausgenutzt werden. Durch den Verzicht auf weitere, nicht mit den thermoelektrischen Generatoren gekoppelte Schalldämpfungseinrichtungen vereinfacht sich der Aufbau.

Bevorzugt ist, wenn der Rohrkanal Lochungen aufweist, welche an nicht mit einem Kühlungselement gekoppelten Wandabschnitten vorgesehen sind. Hierdurch erhöht sich die Schalldämpfung weiter.

Bevorzugt ist der Rohrkanal als Flachkanal ausgebildet, wobei zumindest eine der beiden einander gegenüberliegenden Seitenflächen, welche im Querschnitt die größere Länge aufweisen, mit dem Kühlungselement, insbesondere der Hochtemperaturseite des thermoelektrischen Generators, thermisch gekoppelt ist. Durch die Ausbildung des Rohrkanals als Flachkanal mit ebenen Seitenflächen wird die Verwendung von handelsüblichen Kühlungselementen, insbesondere thermoelektrischen Generatoren, erleichtert. Ferner ermöglicht diese Ausführungsform eine besonders effiziente Ausnutzung der Rohrkanaloberfläche sowie eine hohe Packungsdichte im Schalldämpfergehäuse.

Erfindungsgemäß ist in dem Schalldämpfergehäuse wenigstens eine Kühlvorrichtung angeordnet, welche mit dem Kühlungselement, insbesondere der Niedertemperaturseite des thermoelektrischen Generators thermisch gekoppelt ist. Hierdurch ist eine besonders effiziente Abschirmung der Niedertemperaturseite vom Abgas gewährleistet. Durch die Kühlvorrichtung lässt sich die Temperaturdifferenz zwischen Hoch- und Niedertemperaturseite weiter erhöhen, was den Wirkungsgrad des thermoelektrischen Generators erhöht.

Gemäß einer weiteren bevorzugten Ausführungsform weist die Kühlvorrichtung wenigstens einen kühlmitteldurchströmbaren, insbesondere als Flachkanal ausgebildeten Kühlmittelkanal auf. Hierdurch lässt sich die Effizienz der Kühlung und damit die am thermoelektrischen Generator wirksame Temperaturdifferenz weiter steigern.

Bevorzugt ist, wenn der Kühlkanal als Flachkanal ausgebildet ist, wobei zumindest eine der beiden einander gegenüberliegenden Seitenflächen, welche im Querschnitt die größere Länge aufweisen, mit dem Kühlungselement, insbesondere der Niedertemperaturseite zumindest eines thermoelektrischen Generators gekoppelt ist. Hierdurch verringert sich der im Schalldämpfergehäuse benötigte Bauraum weiter. Insbesondere lässt sich dadurch eine Stapelanordnung realisieren, bei der zwischen einem als Flachkanal ausgebildeten Kühlkanal und einem als Flachkanal ausgebildeten Rohrkanal ein oder mehrere thermoelektrische Generatoren angeordnet sind.

Gemäß einer vorteilhaften Ausführungsform der Erfindung sind die Kühlvorrichtung und der Rohrkanal thermisch über das Kühlungselement, insbesondere den thermoelektrischen Generator und zusätzlich mechanisch über thermisch isolierende Isolationselemente gekoppelt, wobei zwischen der Kühlvorrichtung und dem Rohrkanal wirkende Kräfte im Wesentlichen nur über die Isolationselemente übertragen werden. Hierdurch wird eine besonders effiziente Trennung von Hoch- und Niedertemperaturseite des thermoelektrischen Generators und zugleich eine spannungsfreie Lagerung der thermoelektrischen Generatoren erreicht.

Weitere vorteilhafte Ausführungsformen der Erfindung ergeben sich aus den Unteransprüchen, der Beschreibung und den Zeichnungen.

Die Erfindung wird nachfolgend anhand eines Ausführungsbeispiels mit Bezug auf die Zeichnungen beschrieben. Es zeigen:
- Fig. 1 und 2: perspektivische Schnittansichten von zwei Ausführungsbeispielen eines erfindungsgemäßen Schalldämpfers, und
- Fig. 3 bis 5: perspektivische Schnittansichten von Ausführungsbeispielen eines Schalldämpfers, welche nicht Gegenstand der vorliegenden Erfindung sind.

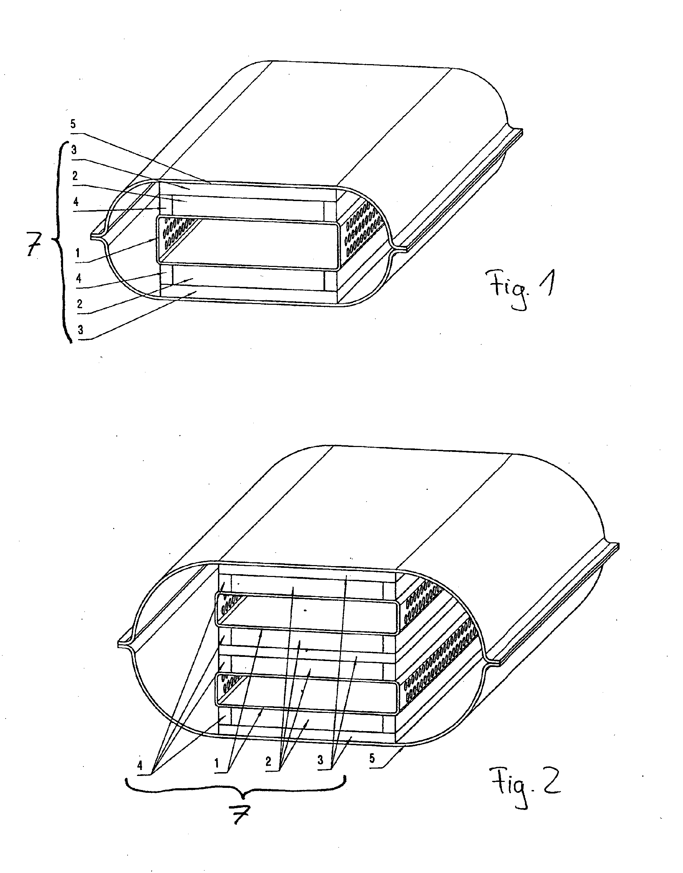

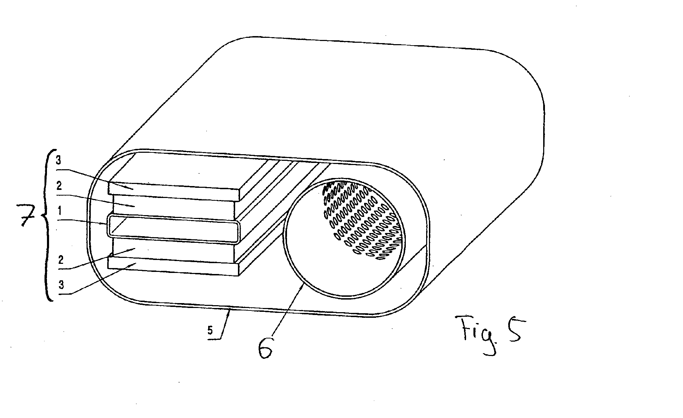

Gemäß Fig. 1 bis 5 umfasst ein Schalldämpfer bei allen Ausführungsbeispielen ein Schalldämpfergehäuse 5, welches einen ovalen Querschnitt aufweist und aus einer Ober- und einer Unterschale zusammengesetzt (Fig. 1 bis 4) bzw. einstückig (Fig. 5) ausgebildet ist. Andere Querschnitte und/oder Bauformen sind möglich. Im Inneren des Schalldämpfergehäuses 5 sind ein oder mehrere von Abgas durchströmbare Rohrkanäle 1 angeordnet, welche mit einem Abgaseinlass und einem Abgasauslass (nicht dargestellt) des Schalldämpfers in bekannter Weise, beispielsweise fest oder mittels Schiebesitz, verbunden sind.

Die Rohrkanäle 1 sind jeweils als Flachkanal mit rechteckigem Querschnitt ausgebildet, wobei die Seitenflächen, welche im Wesentlichen im Querschnitt die größere Länge aufweisen, in der hier gewählten Darstellung in einer horizontalen Ebene verlaufen. Sowohl auf der Oberseite als auch auf der Unterseite der Rohrkanäle 1 sind thermoelektrische Generatoren 2 angeordnet. Derartige thermoelektrische Generatoren 2 sind insbesondere in Form von Modulen verschiedener Größe handelsüblich erhältlich. Sofern hier allgemein von einem thermoelektrischen Generator 2 die Rede ist, schließt dies nicht aus, dass es sich dabei um mehrere nebeneinander und/oder hintereinander angeordnete thermoelektrische Generator-Module handeln kann.

Während die Hochtemperaturseiten der thermoelektrischen Generatoren 2 mit der zugeordneten Außenseite des Rohrkanals 1 in Wärmeleitverbindung stehen, befinden sich die den Hochtemperaturseiten gegenüberliegenden Niedertemperaturseiten der thermoelektrischen Generatoren 2 jeweils mit einer Kühlvorrichtung 3 in Wärmeleitverbindung. Der mindestens eine Rohrkanal 1, die thermoelektrischen Generatoren 2 und die Kühlvorrichtungen 3 sind Bestandteile einer Generatoranordnung 7.

Bei den hier nur schematisch dargestellten Kühlvorrichtungen 3 kann es sich beispielsweise um kühlmitteldurchströmbare Flachkanäle oder auch um Wärmeleitelemente handeln, welche die Niedertemperaturseiten der thermoelektrischen Generatoren 2 mit Temperatursenken verbinden.

Bei den Ausführungsbeispielen gemäß Fig. 1 und 2 weisen diejenigen, sich in vertikaler Richtung erstreckenden Seitenflächen des bzw. der Rohrkanäle 1, welche nicht mit einem thermoelektrischen Generator gekoppelt sind, eine Lochung auf. Die Rohrkanäle 1 bilden hier die einzige Schalldämpfungseinrichtung, wobei damit nicht ausgeschlossen wird, dass in den Hohlräumen zwischen den Rohrkanälen 1 und dem Schalldämpfergehäuse 5 zusätzlich auch Dämpfungsmaterial vorgesehen sein kann.

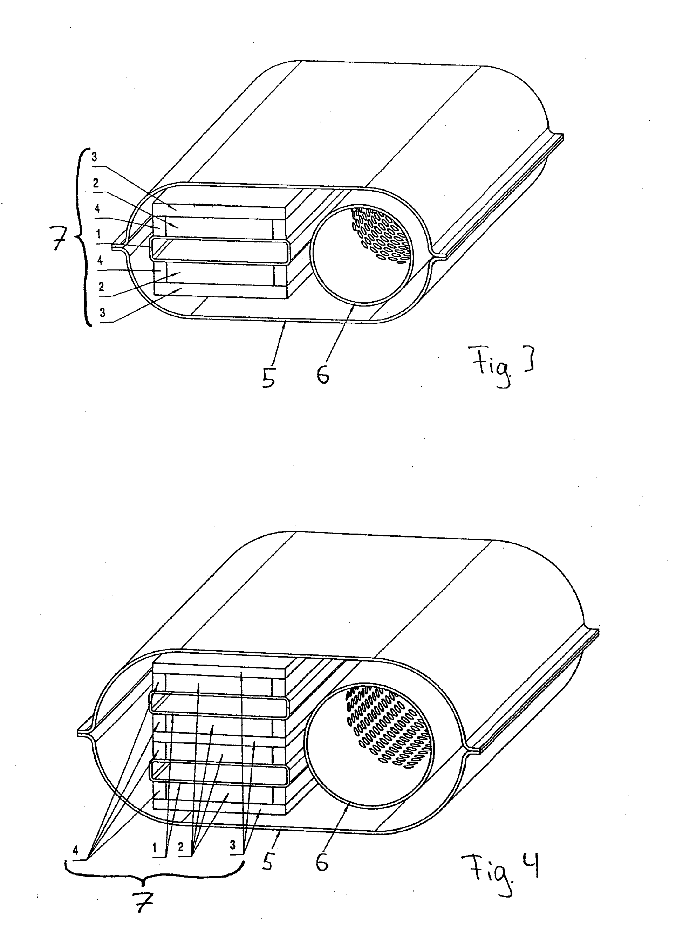

Bei den Ausführungsbeispielen gemäß Fig. 3 bis 5 ist zusätzlich zu der Generatoranordnung 7 eine ebenfalls von Abgas durchströmbare Rohrleitung 6 vorgesehen, die hier einen runden Querschnitt aufweist und mit einer Lochung versehen ist, jedoch nicht mit einem thermoelektrischen Generator gekoppelt ist. Andere Querschnittsformen sind möglich. Die Rohrleitung 6 verläuft parallel zu dem mindestens einen Rohrkanal 1 und steht mit diesem sowohl abgaseinlassseitig als auch abgasauslassseitig in Strömungsverbindung. Die Rohrkanäle 1 weisen bei den Ausführungsbeispielen gemäß Fig. 3 bis 5 keine Lochung auf, wobei alternativ auch hier eine Lochung vorgesehen sein kann.

Mit Bezug auf Fig. 1 bis 4 wird nachfolgend eine besondere Ausgestaltung der Generatoranordnung 7 beschrieben. Zwischen einem Rohrkanal 1 und einer Kühlvorrichtung 3 sind jeweils im Bereich der Rohrkanalkanten Isolationselemente 4 vorgesehen, mittels derer der Rohrkanal 1 und die zugeordnete Kühlvorrichtung 3 mechanisch gekoppelt sind. Die Höhe der Isolationselemente 4 ist gleich groß oder geringfügig großer als die Höhe der thermoelektrischen Generatoren 2, so dass zwischen dem Rohrkanal 1 und der Kühlvorrichtung 3 auftretende Kräfte im Wesentlichen nur über die Isolationselemente 4 übertragen werden. Die Höhe der Isolationselemente 4 ist insbesondere so gewählt, dass zwischen dem thermoelektrischen Generator 2 und dem Rohrkanal 1 bzw. der Kühlvorrichtung 3 jeweils eine ungestörte Wärmeübertragung möglich ist. Das Material der Isolationselemente 4 weist eine möglichst geringe Wärmeleitfähigkeit auf, so dass ein thermischer Kurzschluss zwischen der Hoch- und der Niedertemperaturseite der thermoelektrischen Generatoren 2 vermieden wird.

Im Falle der Ausführungsbeispiele gemäß Fig. 1 und 2 ist die Höhe der Generatoranordnung 7 gleich der Höhe des Schalldämpfergehäuses 5, so dass die zuoberst und zuunterst vorgesehenen Kühlvorrichtungen 3 mit dem Schalldämpfergehäuse in Wärmeleitverbindung stehen. Dadurch stellt das Schalldämpfergehäuse 5 letztlich eine Temperatursenke für die Niedertemperaturseiten der thermoelektrischen Generatoren 2 dar. Somit kann auf eine aktive Kühlung, insbesondere auf einen Kühlmittelkreislauf, verzichtet werden.

Bei den Ausführungsbeispielen gemäß Fig. 3 bis 5 ist die Generatoranordnung 7 von dem Schalldämpfergehäuse 5 beabstandet angeordnet. Dadurch wird die mechanische Belastung der Generatoranordnung 7, welche sich beispielsweise durch unterschiedliche thermische Ausdehnungen ergeben kann, vermindert. Gegebenenfalls kann eine Abstützung zwischen Generatoranordnung 7 und Schalldämpfergehäuse 5 durch geeignete, bevorzugt elastische Stützelemente (nicht dargestellt) vorgesehen werden.

Grundsätzlich können anstelle der in den Figuren dargestellten einzigen Generatoranordnung 7 auch mehrere, insbesondere parallel zueinander angeordnete Generatoranordnungen vorgesehen werden. Außerdem können anstelle der thermoelektrischen Generatoren auch andere Kühlungselemente wie Wärmetauscher, Verdampfungskühler, Rekuperatoren oder Überhitzer vorgesehen sein.

Die erfindungsgemäßen Schalldämpfer können an beliebiger Stelle im Abgasstrang vorgesehen werden, insbesondere als Vor-, Mittel-, oder Endschalldämpfer.

### Bezugszeichenliste

- 1: Rohrkanal
- 2: thermoelektrischer Generator
- 3: Kühlvorrichtung
- 4: Isolierelement
- 5: Schalldämpfergehäuse
- 6: Rohrleitung
- 7: Generatoranordnung

## Patentansprüche

1. Schalldämpfer für eine Abgasanlage einer Brennkraftmaschine mit einem Schalldämpfergehäuse (5), mindestens einem Abgaseinlass, mindestens einem Abgasauslass und einer im Schalldämpfergehäuse (5) angeordneten Schalldämpfungseinrichtung (7),
wobei im Schalldämpfergehäuse (5) mindestens ein Kühlungselement (2) angeordnet ist, welches ausgebildet ist, um dem Abgas Wärmeenergie zu entziehen, und
wobei im Schalldämpfergehäuse (5) mindestens ein abgasdurchströmbarer Rohrkanal (1) angeordnet ist, welcher mit dem Kühlungselement (2) thermisch gekoppelt ist,
**dadurch gekennzeichnet,**
**dass** das Kühlungselement ein thermoelektrischer Generator (2) ist, dessen Hochtemperaturseite mit dem Abgas in Wärmeübertragungsverbindung steht und dessen Niedertemperaturseite vom Abgas abgeschirmt ist,
**dass** in dem Schalldämpfergehäuse (5) wenigstens eine Kühlvorrichtung (3) angeordnet ist, welche mit der Niedertemperaturseite des thermoelektrischen Generators (2) thermisch gekoppelt ist, wobei die genannte Schalldämpfungseinrichtung (7) den Rohrkanal (1), den thermoelektrischen Generator (2) und die Kühlvorrichtung (3) umfasst, und
**dass** in dem Schalldämpfergehäuse (5) außer der genannten Schalldämpfungseinrichtung (7) keine weitere Schalldämpfungseinrichtung angeordnet ist.

2. Schalldämpfer nach Anspruch 1,
**dadurch gekennzeichnet,**
**dass** der abgasdurchströmbare Rohrkanal (1), insbesondere Flachkanal, mit der Hochtemperaturseite des thermoelektrischen Generators (2) thermisch gekoppelt ist.

3. Schalldämpfer nach einem der vorhergehenden Ansprüche,
**dadurch gekennzeichnet,**
**dass** der Rohrkanal (1) Lochungen aufweist, welche an nicht mit einem Kühlungselement (2) gekoppelten Wandabschnitten vorgesehen sind.

4. Schalldämpfer nach einem der vorhergehenden Ansprüche,
**dadurch gekennzeichnet,**
**dass** der Rohrkanal (1) als ein Flachkanal ausgebildet ist, wobei eine der beiden einander gegenüberliegenden Seitenflächen, welche im Querschnitt die größere Länge aufweisen, mit der Hochtemperaturseite des thermoelektrischen Generators (2) thermisch gekoppelt ist.

5. Schalldämpfer nach einem der vorhergehenden Ansprüche,
**dadurch gekennzeichnet,**
**dass** die Kühlvorrichtung (3) wenigstens einen kühlmitteldurchströmbaren, insbesondere als Flachkanal ausgebildeten Kühlmittelkanal aufweist.

6. Schalldämpfer nach Anspruch 5,
**dadurch gekennzeichnet,**
**dass** der Kühlmittelkanal als ein Flachkanal ausgebildet ist, wobei zumindest eine der beiden einander gegenüberliegenden Seitenflächen des Flachkanals, welche im Querschnitt die größere Länge aufweisen, mit der Niedertemperaturseite des thermoelektrischen Generators (2), gekoppelt ist.

7. Schalldämpfer nach einem der vorhergehenden Ansprüche,
**dadurch gekennzeichnet,**
**dass** die Kühlvorrichtung (3) und der Rohrkanal (1) thermisch über den thermoelektrischen Generator (2) und zusätzlich mechanisch über thermisch isolierende Isolationselemente (4) gekoppelt sind, wobei zwischen der Kühlvorrichtung (3) und dem Rohrkanal (1) wirkende Kräfte im Wesentlichen nur über die Isolationselemente (4) übertragen werden.

## Claims

1. A muffler for an exhaust gas system of an internal combustion engine having a muffler housing (5), at least one exhaust gas inlet, at least one exhaust gas outlet and a muffling device (7) arranged in the muffler housing (5),
wherein at least one cooling element (2) which is configured to extract heat energy from the exhaust gas is arranged in the muffler housing (5); and
wherein at least one duct (1) which can be flowed through by exhaust gas is arranged in the muffler housing (5) and is thermally coupled to the cooling element (2),
**characterized in that**
the cooling element is a thermoelectric generator (2) whose high temperature side is in thermal transfer communication with the exhaust gas and whose low temperature side is shielded from the exhaust gas;
**in that** at least one cooling apparatus (3) is arranged in the muffler housing (5) and is thermally coupled to the low temperature side of the thermoelectric generator (2), with the named muffling device (7) comprising the duct (1), the thermoelectric generator (2) and the cooling apparatus (3); and
**in that** no further muffling device is arranged in the muffler housing (5) except for the named muffling device (7).

2. A muffler in accordance with claim 1,
**characterized in that**
the duct (1), in particular a flat passage, which can be flowed through by exhaust gas is thermally coupled to the high temperature side of the thermoelectric generator (2).

3. A muffler in accordance with one of the preceding claims,
**characterized in that**
the duct (1) has perforations which are provided at wall sections not coupled to a cooling element (2).

4. A muffler in accordance any one of the preceding claims,
**characterized in that**
the duct (1) is formed as a flat passage, with one of the two mutually oppositely disposed side surfaces, which have the larger length in cross-section, being thermally coupled to the high temperature side of the thermoelectric generator (2).

5. A muffler in accordance with any one of the preceding claims,
**characterized in that**
the cooling device (3) has at least one coolant passage which can be flowed through by coolant and which is in particular formed as a flat passage.

6. A muffler in accordance with claim 5,
**characterized in that**
the coolant passage is configured as a flat passage, with at least one of the two mutually oppositely disposed side surfaces of the flat passage, which have the larger length in cross-section, being coupled to the low temperature side of the thermoelectric generator (2).

7. A muffler in accordance with any one of the preceding claims,
**characterized in that**
the cooling device (3) and the duct (1) are thermally coupled via the thermoelectric generator (2), and additionally mechanically via thermally insulating insulation elements (4), with forces active between the cooling device (3) and the duct (1) substantially only being transmitted via the insulation elements (4).

## Revendications

1. Silencieux pour une installation de gaz d'échappement d'un moteur à combustion interne, comprenant un boîtier de silencieux (5), au moins une entrée de gaz d'échappement, au moins une sortie de gaz d'échappement et un système silencieux (7) agencé dans le boîtier de silencieux (5),
dans lequel au moins un élément de refroidissement (2) est agencé dans le boîtier de silencieux (5), lequel est réalisé pour extraire de l'énergie thermique hors des gaz d'échappement, et
dans lequel au moins un canal tubulaire (1) susceptible d'être traversé par le flux des gaz d'échappement est agencé dans le boîtier de silencieux (5), lequel est couplé thermiquement avec l'élément de refroidissement (2),
**caractérisé en ce que**
l'élément de refroidissement est un générateur thermoélectrique (2), dont le côté à haute température est en liaison de transfert thermique avec les gaz d'échappement et dont le côté à basse température est isolé vis-à-vis des gaz d'échappement,
**en ce qu'**au moins un dispositif de refroidissement (3) est agencé dans le boîtier de silencieux (5), lequel est couplé thermiquement avec le côté à basse température du générateur thermoélectrique (2), et ledit système silencieux (7) englobe le canal tubulaire (1), le générateur thermoélectrique (2) et le dispositif de refroidissement (3), et **en ce que** outre ledit système silencieux (7) aucun autre moyen silencieux n'est agencé dans le boîtier de silencieux (5).

2. Silencieux selon la revendication 1,
**caractérisé en ce que** le canal tubulaire (1) susceptible d'être traversé par le flux des gaz d'échappement, en particulier un canal aplati, est couplé thermiquement avec le côté à haute température du générateur thermoélectrique.

3. Silencieux selon l'une des revendications précédentes,
**caractérisé en ce que** le canal tubulaire (1) comporte des perçages qui sont prévus sur des portions de paroi qui ne sont pas couplées avec un élément de refroidissement (2).

4. Silencieux selon l'une des revendications précédentes,
**caractérisé en ce que** le canal tubulaire (1) est réalisé sous forme d'un canal aplati, dans lequel l'une des deux surfaces latérales mutuellement opposées qui présentent en section transversale la plus grande longueur, est couplée thermiquement avec le côté à haute température du générateur thermoélectrique (2).

5. Silencieux selon l'une des revendications précédentes,
**caractérisé en ce que** le dispositif de refroidissement (3) comprend au moins un canal à réfrigérant, en particulier réalisé sous forme de canal aplati, susceptible d'être traversé par un flux de réfrigérant.

6. Silencieux selon la revendication 5,
**caractérisé en ce que** le canal à réfrigérant est réalisé sous forme de canal aplati, dans lequel l'une au moins des deux surfaces latérales mutuellement opposées du canal aplati qui présentent en section transversale la plus grande longueur, et couplée avec le côté à basse température du générateur thermoélectrique (2).

7. Silencieux selon l'une des revendications précédentes,
**caractérisé en ce que** le dispositif de refroidissement (3) et le canal tubulaire (1) sont couplés thermiquement via le générateur thermoélectrique (2) et en supplément mécaniquement via des éléments d'isolation (4) à fonction d'isolation thermique, dans lequel des forces agissant entre le dispositif de refroidissement (3) et le canal tubulaire (1) sont transmises essentiellement uniquement via les éléments d'isolation (4).
